# EUROPÄISCHE PATENTSCHRIFT

(11) **EP 3 276 308 B1**
(45) Veröffentlichungstag und Bekanntmachung des Hinweises auf die Patenterteilung: **05.09.2018**
(21) Anmeldenummer: 16181379.5
(22) Anmeldetag: 27.07.2016
(51) Int. Cl.: G01D 3/028

(54) **MESSGERÄT**
MEASURING APPARATUS
APPAREIL DE MESURE

(43) Veröffentlichungstag der Anmeldung: 31.01.2018
(73) Patentinhaber: Siemens Aktiengesellschaft, 80333 München (DE)
(72) Erfinder: Kirsammer, Florian, 76131 Karlsruhe (DE); Kleih, Hans-Günther, 76646 Bruchsal (DE); Ludwig, Michael, 76149 Karlsruhe (DE); Marcaux, Günter, 76187 Karlsruhe (DE)

(56) Entgegenhaltungen:
- DE-A1-102012 212 982
- DE-B3-102012 212 978
- FR-A1- 2 820 211

## Beschreibung

Die Erfindung betrifft ein Messgerät für eine nichtelektrische Größe
- mit einer Messeinheit, die dazu ausgebildet ist, die nichtelektrische Größe indirekt mittels eines elektrischen Wechselstroms der Frequenz in ein elektrisches Messsignal zu überführen, wobei das elektrische Messsignal einen von der nichtelektrischen Größe abhängigen Nutzsignalanteil mit der doppelten Frequenz und einen von dem Wechselstrom abhängigen Störsignalanteil mit der Frequenz enthält,
- mit einer Signalvorverarbeitungseinrichtung zur Vorverarbeitung und Digitalisierung des Messsignals zu einem Digitalsignal, und
- mit einer Signalverarbeitungseinrichtung zur Verarbeitung des Digitalsignals mittels einer Signalverarbeitungssoftware zu einem Messwert, wobei die Signalverarbeitungssoftware dazu ausgebildet ist,
   - das Digitalsignal durch Multiplikation mit einem Referenzsignal bei der doppelten Frequenz phasensensitiv zu detektieren und durch anschließende Tiefpassfilterung zu dem zu der nichtelektrischen Größe proportionalen Messwert zu verarbeiten und
   - das Digitalsignal durch Multiplikation mit einem weiteren Referenzsignal bei der einfachen Frequenz phasensensitiv zu detektieren und durch anschließende Tiefpassfilterung zu einem Störsignalwert zu verarbeiten.

Bei einem derartigen, aus der DE 10 2012 212 978 B3 bekannten Messgerät dient der oben erwähnte weitere Wert als Diagnosewert. Dabei wird die Erkenntnis genutzt, dass in vielen Fällen bei einer modulierten Umwandlung einer nichtelektrischen Größe in ein elektrisches Messsignal ein Störsignalanteil mit der doppelten oder halben Modulationsfrequenz in das eigentliche Messsignal (Nutzsignal) gelangt. Anstatt solche Störsignalanteile mittels geeigneter Filtermaßnahmen so weit zu dämpfen, dass sie keinen Einfluss mehr auf das Messergebnis haben, werden die Störanteile genutzt, um im laufenden Messbetrieb den kompletten Signalverarbeitungspfad von der Modulation bis zur Messwertermittlung zu überwachen. Dabei wird der Diagnosewert mit einem Erwartungswert verglichen. Solange der Diagnosewert innerhalb eines Toleranzbereichs um den Erwartungswert liegt, kann die Signalverarbeitung als fehlerfrei angesehen werden. Im anderen Fall wird eine Fehler- oder Alarmmeldung erzeugt und beispielsweise der Messwert sicherheitsgerichtet eingestellt.

Als Beispiel für das bekannte Messgerät ist ein nach dem paramagnetischen Wechseldruckverfahren arbeitender Gasanalysator angegeben, der die paramagnetischen Eigenschaften von Sauerstoff zur Erzeugung des Messeffekts nutzt. Dazu wird ein Elektromagnet mit einem Wechselstrom bestimmter Frequenz f angesteuert. Da der Messeffekt proportional zum Quadrat des Magnetfeldes ist, enthält das analoge elektrische Messsignal einen von der nichtelektrischen Größe abhängigen Nutzsignalanteil mit der doppelten Frequenz 2f. Aufgrund transformatorischer Einkopplung findet sich in dem elektrischen Messsignal außerdem noch ein Störsignalanteil mit der Ansteuerfrequenz des Elektromagneten, also der einfachen Frequenz f.

Änderungen von Eigenschaften des Magnetkreises wie z. B. Wicklungswiderstand oder Induktivität beeinflussen den paramagnetischen Messeffekt und damit den Messwert.

Der Erfindung liegt die Aufgabe zugrunde, eine solche Messwertbeeinflussung mit geringstmöglichem gerätetechnischem Aufwand zu minimieren.

Gemäß der Erfindung wird die Aufgabe dadurch gelöst, dass bei dem Messgerät der eingangs angegebenen Art die Signalverarbeitungseinrichtung eine Normalisierungsstufe aufweist, die dazu ausgebildet ist, den Messwert mit dem Quadrat des Störsignalwerts durch Quotientenbildung zu normalisieren und als normalisierten Messwert auszugeben.

Vorteilhafte Weiterbildungen des erfindungsgemäßen Messgeräts sind in den Unteransprüchen angegeben.

Die Umwandlung der nichtelektrischen Größe in das elektrische Messsignal erfolgt mittels des elektrischen Wechselstroms und leistungsbezogen, so dass der Nutzsignalanteil die doppelte Frequenz 2f des Wechselstroms hat. Der wesentliche Vorteil des erfindungsgemäßen Messgeräts besteht nun darin, dass der durch die Signalverarbeitung aus dem Nutzsignalanteil ermittelte Messwert mit dem Quadrat, also der Leistung des Wechselstroms, normalisiert wird, ohne dass dieser gemessen werden muss. Damit entfällt jeder gerätetechnische Aufwand, der mit einer Strommessung verbunden wäre.

Ein weiterer Vorteil besteht darin, dass der Nutzsignalanteil und der zu seiner Normalisierung verwendete Störsignalanteil dieselbe analoge und praktisch dieselbe digitale Signalverarbeitung durchlaufen, so dass die Auswirkung Störungen oder Änderungen im Signalpfad auf den Messwert bei seiner Normalisierung kompensiert werden.

Es ist möglich, dass die Signalverarbeitungssoftware den Störsignalwert abwechselnd mit dem Messwert ermittelt oder dass die Signalverarbeitungssoftware in doppelter Ausführung vorhanden ist und das bei der doppelten Frequenz detektierte Digitalsignal und das bei der einfachen Frequenz detektierte Digitalsignal parallel verarbeitet.

Bei der Messeinheit des erfindungsgemäßen Messgeräts kann es sich insbesondere um eine nach dem paramagnetischen Wechseldruckverfahren, dem thermisch-physikalischem Prinzip oder dem optischen Prinzip arbeitende Messeinheit, vorzugsweise einen Gasanalysator handeln.

Zur weiteren Erläuterung der Erfindung wird im Folgenden auf die Figuren der Zeichnung Bezug genommen; im Einzelnen zeigen jeweils beispielhaft:
- Figur 1: ein Blockschaltbild des erfindungsgemäßen Messgeräts,
- Figur 2: eine Messeinheit in Form eines nach dem paramagnetischen Wechseldruckverfahren arbeitenden Gasanalysators,
- Figur 3: eine prinzipielle Darstellung einer Messeinheit in Form eines Wärmeleitfähigkeit-Gasanalysators,
- Figur 4: eine prinzipielle Darstellung einer Messeinheit in Form eines Strömungssensors und
- Figur 5: ein Ausführungsbeispiel für den Strömungssensor.

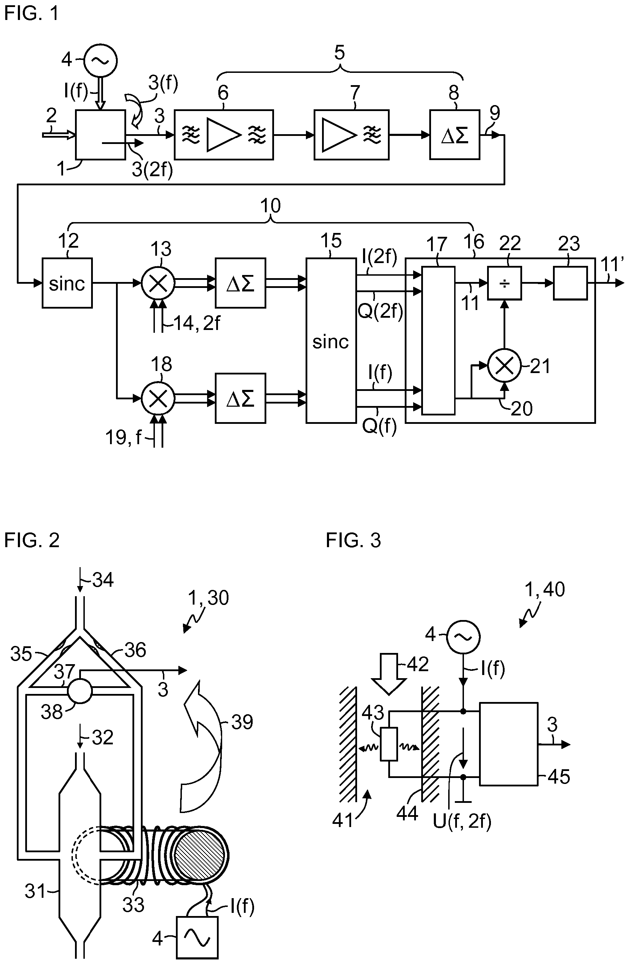

Das in Figur 1 gezeigte Messgerät weist eine Messeinheit 1 auf, die eine nichtelektrische Größe 2 in ein elektrisches Messsignal (Rohsignal) 3 umwandelt. Die Umwandlung erfolgt mittels eines sinusförmigen elektrischen Wechselstroms I(f) der Frequenz f, der von einer Strom- oder Spannungsquelle 4 geliefert wird. Die Strom- oder Spannungsquelle 4 kann auch Bestandteil der Messeinheit 1 sein. Die Umwandlung erfolgt leistungsbezogen, so dass das Messsignal 3 einen Nutzsignalanteil 3(2f) mit der doppelten Frequenz 2f enthält. So werden im Falle eines nach dem paramagnetischen Wechseldruckverfahren arbeitenden Gasanalysators Sauerstoffmoleküle in einem durch den Wechselstrom I(f) erzeugten Wechsel-Magnetfeld bewegt; werden zwei Gase mit unterschiedlichem Sauerstoffgehalt in dem Magnetfeld zusammengeführt, so entsteht zwischen ihnen ein alternierender Druckunterschied, der als Messsignal 3 erfasst wird. Bei einem nach dem thermisch-physikalischen Prinzip arbeitenden Messgerät, z. B. Gasanalysator, wird mit dem Wechselstrom I(f) ein Heizelement erhitzt, um über den Wärmefluss auf das umgebende Gas dessen Wärmeleitfähigkeit oder Strömung zu detektieren. Bei einem nach dem optischen Prinzip arbeitenden Gasanalysator wird mit dem Wechselstrom I(f) eine Strahlungsquelle angesteuert, deren Strahlung nach Durchgang durch oder Reflexion an einem Messmedium gemessen wird. In allen beispielhaft genannten Fällen ist der Nutzsignalanteil 3(2f) des Messsignals proportional zum Quadrat des Wechselstroms I(f).

Bei der Umwandlung der nichtelektrischen Größe 2 in das Messsignal 3 kann außerdem ein Störsignalanteil 3(f) mit der Frequenz f des Wechselstroms I(f) in das Messsignal 3 gelangen. So kann z. B. in Falle des nach dem paramagnetischen Wechseldruckverfahren arbeitenden Gasanalysators der Störsignalanteil 3(f) durch transformatorische Kopplung zwischen dem Elektromagneten und dem Sensor zur Erfassung des Druckunterschieds und/oder der nachgeordneten Elektronik in das Messsignal 3 gelangen. Bei dem oben erwähnten nach dem thermisch-physikalischen Prinzip arbeitenden Messgerät ist die als Messsignal 3 verwendbare Spannung über dem Heizelement sowohl von dem Wechselstrom I(f) als auch von der Widerstandsänderung des Heizelements durch Wechselstrom I(f) und den Wärmefluss in das umgebende Messmedium abhängig, wobei die Widerstandsänderung mit der doppelten Frequenz 2f variiert.

Das Messsignal 3 mit dem Nutzsignalanteil 3(2f) und Störsignalanteil 3(f) wird in einer Signalvorverarbeitungseinrichtung 5 in mehreren Stufen 6, 7, 8 gefiltert, verstärkt und durch Delta-Sigma-Modulation bei Überabtastung in ein bitserielles Digitalsignal (Bitstream) 9 umgesetzt. Im Weiteren wird der Nutzsignalanteil in dem Digitalsignal 9 in einer digitalen Signalverarbeitungseinrichtung 10 mittels einer Signalverarbeitungssoftware zu einem Messwert 11 verarbeitet. Dazu wird das bitserielle Digitalsignal 9 zunächst in einem Sinc-Filter 12 tiefpassgefiltert und in der Abtastrate dezimiert. Anschließend wird das tiefpassgefilterte Digitalsignal 9 durch Multiplikation 13 mit einem Referenzsignal 14 und dem um 90° phasenverschobenen Referenzsignal 14 (Sinus-Cosinus-Multiplikation) bei der doppelten Frequenz 2f phasensensitiv detektiert, um durch anschließende Tiefpassfilterung 15 die Inphasenkomponente I(2f) und Quadraturkomponente Q(2f) zu ermitteln (Zweiphasen-Lock-In-Technik, z. B. EP 2 130 295 B1) und in weiteren Signalverarbeitungsschritten 16 zu dem Messwert 11 zu verarbeiten. Die weiteren Signalverarbeitungsschritte 16 beinhalten beispielsweise ein FIR Hamming-Filterung 17.

Der Störsignalanteil in dem tiefpassgefilterten und bezüglich der Abtastrate dezimierten Digitalsignal 9 wird durch eine weitere Sinus-Cosinus-Multiplikation 18 mit einem Referenzsignal 19 bei der einfachen Frequenz f phasensensitiv detektiert. Durch die anschließende Tiefpassfilterung 15 werden die Inphasenkomponente I(2f) und Quadraturkomponente Q(2f) ermittelt und in den weiteren Signalverarbeitungsschritten 16 zu einem Störsignalwert 20 verarbeitet. Abgesehen von der anderen Multiplikation durchläuft die Verarbeitung des Störsignalanteils dieselben Schritte wie die des Nutzsignalanteils des Messsignals 3. Dabei kann die Signalverarbeitung nach der Multiplikation 13 bzw. 18 parallel oder abwechselnd erfolgen.

Der Störsignalwert 20 wird in einem Multiplizierer 21 quadriert und anschließend einer Normalisierungsstufe 22 zugeführt, in der der Messwert 11 mit dem Quadrat des Störsignalwerts 20 durch Quotientenbildung normalisiert und ggf. nach weiteren Verarbeitungsschritten 23 wie Temperatur- und/oder Druckkompensation als normalisierter Messwert 11' ausgegeben, beispielsweise zur Anzeige gebracht oder an andere Geräte innerhalb eines Prozessautomatisierungssystems kommuniziert werden.

Wie aus der eingangs erwähnten DE 10 2012 212 978 B3 bekannt und hier nicht eigens dargestellt, kann den Störsignalwert 20 in einer Vergleichseinrichtung mit einem Erwartungswert verglichen werden, der in einem Speicher abgelegt ist und zuvor berechnet oder bei einer Kalibrierung des intakten Messgeräts ermittelt worden ist. Weicht der Diagnosewert 20 um mehr als ein erlaubtes Maß von dem Erwartungswert ab, kann eine Fehlermeldung erzeugt und zum Beispiel mittels der Messwert 11' auf einen sicherheitsgerichteten Wert festgesetzt werden.

Figur 2 zeigt beispielhaft eine Messeinheit 1 in Form eines nach dem paramagnetischen Wechseldruckverfahren arbeitenden Gasanalysators 30. Die Messeinheit 1 weist eine Messkammer 31 auf, die von einem Messgas 32, dessen Sauerstoffanteil bestimmt werden soll, durchströmt wird. Ein Teil der Messkammer 31 liegt zwischen den Polschuhen eines wechselstromgespeisten Elektromagneten 33 in dem von ihm erzeugten Magnetfeld. Der Elektromagnet 33 wird von der Strom- oder Spannungsquelle 4 mit dem Wechselstrom I(f) der Frequenz f angesteuert. Ein zur Erzielung des Messeffekts notwendiges Vergleichsgas 34 wird der Messkammer 31 durch zwei gleichförmige Kanäle 35, 36 zugeführt, wobei einer der beiden Vergleichsgasströme im Bereich des Magnetfeldes mit dem Messgas 32 zusammentrifft. Da Sauerstoffmoleküle aufgrund ihrer paramagnetischen Eigenschaft in dem Magnetfeld in Richtung höherer Feldstärke bewegt werden, entsteht zwischen den Vergleichsgasströmen in den Kanälen 35, 36 eine wechselnde Druckdifferenz mit der Frequenz 2f. Diese bewirkt in einem Verbindungskanal 37 zwischen den beiden Kanälen 35, 36 eine Wechselströmung, die mittels eines Mikroströmungsfühlers 38 erfasst und in das elektrische Messsignal 3 umgewandelt wird. Wie durch den Pfeil 39 angedeutet ist, wird dem Messsignal 3 mit der Frequenz 2f durch transformatorische Kopplung zwischen dem Elektromagneten 33 und dem Strömungsfühler 38 bzw. der nachgeordneten Elektronik 5 (Figur 1) ein Störsignalanteil 3(f) mit der Frequenz f des Wechselstroms I(f) überlagert.

Figur 3 zeigt beispielhaft das Prinzip einer Messeinheit 1 in Form eines Wärmeleitfähigkeit-Gasanalysators 40. Die Messeinheit 1 weist einen Messkanal 41 auf, der von einem Messgas 42 mit zwei oder ggf. mehr unterschiedlichen Gaskomponenten durchströmt wird. In dem Messkanal 41 ist ein Heizwiderstand 43 so angeordnet, dass er sich in Längsrichtung des Messkanals 41 erstreckt und von dem Messgas 42 umströmt wird. Der Heizwiderstand 43 wird von der Strom- oder Spannungsquelle 4 mit dem Wechselstrom I(f) der Frequenz f angesteuert, so dass die Heizleistung mit dem Quadrat des Wechselstroms I(f) und der doppelten Frequenz 2f pulsiert. Es findet ein Wärmefluss von dem Heizwiderstand 43 zu der Wand 44 des Messkanals 41 hin statt, wobei der Wärmefluss von der Wärmeleitfähigkeit des Messgases 42 abhängig ist. Der temperaturabhängige elektrische Widerstand des Heizwiderstands 43 ist daher von dem Quadrat des Wechselstroms I(f) und der Wärmeleitfähigkeit des Messgases 42 abhängig und ändert sich mit der doppelten Frequenz 2f. Über dem Heizwiderstand 43 fällt eine Spannung U(f, 2f) ab, die einen Informationen über die Wärmeleitfähigkeit und damit die Zusammensetzung des Messgases 42 enthaltenden Nutzsignalanteil mit der doppelten Frequenz 2f sowie einen Störsignalanteil mit der einfachen Frequenz f enthält. Diese Spannung wird mit einer Spannungsmesseinrichtung 45 erfasst und bildet das Messsignal 3, das entsprechend nach dem Beispiel aus Figur 1, weiterverarbeitet werden kann. In der Praxis kann der Heizwiderstand 43 zusammen mit Referenzwiderständen in einer Messbrücke angeordnet sein, die mit dem Wechselstrom I(f) gespeist wird und deren Diagonalspannung als Messsignal 3 erfasst wird. Wird der Heizwiderstand 43 so angeordnet, dass er sich quer zur Längsrichtung des Messkanals 41 erstreckt, findet der Wärmefluss im Wesentlichen quer in Strömungsrichtung des Messgases 42 statt, so dass die Messeinheit 1 als Strömungs- oder Durchflusssensor arbeitet.

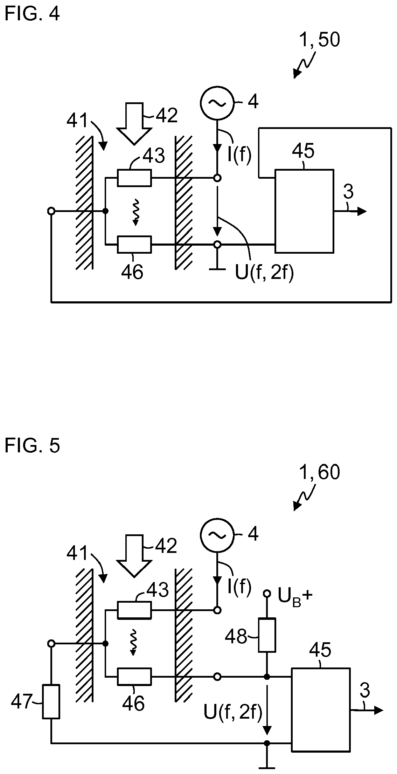

Figur 4 zeigt beispielhaft das Prinzip einer Messeinheit 1 in Form eines kalorimetrischen Strömungssensors 50. Der Strömungssensor 50 unterscheidet sich von dem in Figur 3 gezeigten Wärmeleitfähigkeits-Gasanalysators 40 im Wesentlichen dadurch, dass ein zweiter temperaturabhängiger Widerstand 46 vorhanden ist, der in Strömungsrichtung des Messgases 42 oder allgemein eines Fluids 42 gesehen hinter dem Heizwiderstand 43 angeordnet ist und beide Widerstände 43, 46 quer zur Strömungsrichtung ausgerichtet sind. Bei dem gezeigten Beispiel sind die Widerstände 43, 46 in Reihe geschaltet und bilden eine bauliche Einheit mit drei Anschlüssen. Die Reihenschaltung der Widerstände 43, 46 wird von der Strom- oder Spannungsquelle 4 mit dem Wechselstrom I(f) der Frequenz f angesteuert, so dass die Heizleistung mit dem Quadrat des Wechselstroms I(f) und der doppelten Frequenz 2f pulsiert. Es findet ein Wärmefluss von dem Heizwiderstand 43 zu dem temperaturabhängigen Widerstand 46 hin statt, wobei der Wärmefluss von der Wärmeleitfähigkeit und Strömung des Fluids 42 abhängig ist. Bei unveränderlicher Zusammensetzung des Fluids 42 variiert der Wärmefluss nur noch mit der Strömung. Der temperaturabhängige Widerstand 46 ändert sich mit dem Quadrat des Wechselstroms I(f) und somit mit der doppelten Frequenz 2f. Über dem temperaturabhängigen Widerstand 46 fällt eine Spannung U(f, 2f) ab, die einen Informationen über die Wärmeleitfähigkeit und damit die Zusammensetzung des Fluids 42 enthaltenden Nutzsignalanteil mit der doppelten Frequenz 2f sowie einen Störsignalanteil mit der einfachen Frequenz f enthält. Diese Spannung wird mit einer Spannungsmesseinrichtung 45 erfasst und bildet das Messsignal 3, das entsprechend nach dem Beispiel aus Figur 1, weiterverarbeitet werden kann. In der Praxis können der Heizwiderstand 43 und der temperaturabhängige Widerstand 46 zusammen mit Referenzwiderständen in einer Messbrücke angeordnet sein, die mit dem Wechselstrom I(f) gespeist wird und deren Diagonalspannung als Messsignal 3 erfasst wird.

Bei dem in Figur 4 gezeigten Beispiel wird neben dem Heizwiderstand 43 auch der temperaturabhängige Widerstand 46 durch den Strom I(f) aufgeheizt.

Figur 5 zeigt ein Ausführungsbeispiel des kalorimetrischen Strömungssensors 60, bei dem im Unterschied zu dem oben beschriebenen Beispiel der Strom I(f) an dem Anschluss zwischen dem Heizwiderstand 43 und dem temperaturabhängigen Widerstand 46 an diesem vorbei über einen Ergänzungswiderstand 47 gegen Masse abgeleitet wird. Der temperaturabhängige Widerstand 46 ist über einen weiteren Ergänzungswiderstand 48 an einer Spannungsquelle mit einer Gleichspannung U_{B+} angeschlossen. Die Spannungsmesseinrichtung 45 erfasst die über den Widerständen 46, 47 abfallende Spannung U(f, 2f) und bildet das Messsignal 3, das entsprechend nach dem Beispiel aus Figur 1, weiterverarbeitet werden kann. Die Spannung U(f, 2f) besteht aus der durch den Wechselstrom I(f) bewirkten Teilspannung über dem Ergänzungswiderstand 47 mit der Frequenz f und der über dem temperaturabhängigen Widerstand 46 abfallenden Teilspannung, die den die Informationen über die Strömung enthaltenden Nutzsignalanteil mit der doppelten Frequenz 2f enthält.

## Patentansprüche

1. Messgerät für eine nichtelektrische Größe
- mit einer Messeinheit (1), die dazu ausgebildet ist, die nichtelektrische Größe (2) indirekt mittels eines elektrischen Wechselstroms der Frequenz (f) in ein elektrisches Messsignal (3) zu überführen, wobei das elektrische Messsignal (3) einen von der nichtelektrische Größe (2) abhängigen Nutzsignalanteil (3(2f)) mit der doppelten Frequenz (2f) und einen von dem Wechselstrom (I(f)) abhängigen Störsignalanteil (3(f)) mit der Frequenz (f) enthält,
- mit einer Signalvorverarbeitungseinrichtung (5) zur Vorverarbeitung und Digitalisierung des Messsignals (3) zu einem Digitalsignal (9), und
- mit einer Signalverarbeitungseinrichtung (10) zur Verarbeitung des Digitalsignals (9) mittels einer Signalverarbeitungssoftware zu einem Messwert (11), wobei die Signalverarbeitungssoftware dazu ausgebildet ist,
- das Digitalsignal (9) durch Multiplikation (13) mit einem Referenzsignal (14) bei der doppelten Frequenz (2f) phasensensitiv zu detektieren und durch anschließende Tiefpassfilterung (15) zu dem zu der nichtelektrischen Größe (2) proportionalen Messwert (11) zu verarbeiten und
- das Digitalsignal (9) durch Multiplikation (18) mit einem weiteren Referenzsignal (19) bei der einfachen Frequenz (f) phasensensitiv zu detektieren und durch anschließende Tiefpassfilterung (15) zu einem Störsignalwert (20) zu verarbeiten,
**dadurch gekennzeichnet,**
- **dass** die Signalverarbeitungseinrichtung (10) eine Normalisierungsstufe (22) aufweist, die dazu ausgebildet ist, den Messwert (11) mit dem Quadrat des Störsignalwerts (20) durch Quotientenbildung zu normalisieren und als normalisierten Messwert (11') auszugeben.

2. Messgerät nach Anspruch 1, **dadurch gekennzeichnet, dass** die Signalverarbeitungssoftware das bei der doppelten Frequenz (2f) detektierte Digitalsignal (9) und das bei der einfachen Frequenz detektierte Digitalsignal (9) abwechselnd verarbeitet.

3. Messgerät nach Anspruch 1, **dadurch gekennzeichnet, dass** die Signalverarbeitungssoftware in doppelter Ausführung vorhanden ist und das bei der doppelten Frequenz (2f) detektierte Digitalsignal (9) und das bei der einfachen Frequenz detektierte Digitalsignal (9) parallel verarbeitet.

4. Messgerät nach einem der Ansprüche 1 bis 3, **dadurch gekennzeichnet, dass** die Messeinheit (1) einen nach dem paramagnetischen Wechseldruckverfahren arbeitenden Gasanalysator (30) mit einem ein Magnetfeld mit wechselnder Flussstärke erzeugenden Elektromagneten (33) umfasst, der mit dem Wechselstrom (I(f)) angesteuert wird.

5. Messgerät nach einem der Ansprüche 1 bis 3, **dadurch gekennzeichnet, dass** die Messeinheit (1, 40, 50, 60) einen mit dem Wechselstrom (I(f)) angesteuerten Heizwiderstand (43) umfasst und dazu ausgebildet ist, die nichtelektrische Größe nach dem thermisch-physikalischen Prinzip in das elektrische Messsignal (3) zu überführen.

6. Messgerät nach Anspruch 5, **dadurch gekennzeichnet, dass** die Messeinheit (1) ein Wärmeleitfähigkeits-Gasanalysator (40) ist.

7. Messgerät nach Anspruch 5, **dadurch gekennzeichnet, dass** die Messeinheit (1) ein Strömungssensor, insbesondere ein kalorimetrischer Strömungssensor (40, 50) ist.

8. Messgerät nach einem der Ansprüche 1 bis 3, **dadurch gekennzeichnet, dass** die Messeinheit (1) einen nach dem optischen Prinzip arbeitenden Gasanalysator mit einer Strahlungsquelle umfasst, der mit dem Wechselstrom (I(f)) angesteuert wird.

9. Messgerät nach einem der vorangehenden Ansprüche, **dadurch gekennzeichnet, dass** die Signalverarbeitungseinrichtung (10) Mittel zur Überwachung der Signalvorverarbeitungseinrichtung (5) und Signalverarbeitungseinrichtung (10) durch Vergleich des Störsignalwerts (20) mit einem Erwartungswert aufweist.

## Claims

1. Measuring device for a non-electrical variable,
- having a measuring unit (1) that is intended to convert the non-electrical variable (2) indirectly into an electrical measurement signal (3) by means of an electrical alternating current of a frequency (f), wherein the electrical measurement signal (3) contains a useful signal portion (3(2f)), which is dependent on the non-electrical variable (2) and is of the double frequency (2f), and a fault signal portion (3(f)), which is dependent on the alternating current (I(f)) and is of the frequency (f),
- having a signal pre-processing device (5) for pre-processing and digitalisation of the measurement signal (3) to give a digital signal (9), and
- having a signal processing device (10) for processing the digital signal (9) by means of signal processing software to give a measured value (11), wherein the signal processing software is intended to:
- detect the digital signal (9) in a phase-sensitive manner, by multiplication (13) with a reference signal (14) at the double frequency (2f), and process it by subsequent low-pass filtering (15) to give the measured value (11), which is proportional to the non-electrical variable (2), and
- detect the digital signal (9) in a phase-sensitive manner, by multiplication (18) with a further reference signal (19) at the single frequency (f), and process it by subsequent low-pass filtering (15) to give a fault signal value (20),
**characterised in that**
- the signal processing device (10) has a normalising stage (22) that is intended to normalise the measured value (11) by forming the quotient using the square of the fault signal value (20), and to output it as a normalised measured value (11') .

2. Measuring device according to claim 1, **characterised in that** the signal processing software processes the digital signal (9) that is detected at the double frequency (2f) and the digital signal (9) that is detected at the single frequency alternately.

3. Measuring device according to claim 1, **characterised in that** the signal processing software is present in duplicate and processes the digital signal (9) detected at the double frequency (2f) and the digital signal (9) detected at the single frequency in parallel.

4. Measuring device according to one of claims 1 to 3, **characterised in that** the measuring unit (1) includes a gas analyser (30) that operates by the paramagnetic alternating pressure method, which has an electromagnet (33) that generates a magnetic field of alternating flow strength and is controlled at the alternating current (I(f)).

5. Measuring device according to one of claims 1 to 3, **characterised in that** the measuring unit (1, 40, 50, 60) includes a heating resistor (43) that is controlled at the alternating current (I(f)) and is intended to convert the non-electrical variable into the electrical measuring signal (3) by the thermo-physical principle.

6. Measuring device according to claim 5, **characterised in that** the measuring unit (1) is a thermal conductivity gas analyser (40).

7. Measuring device according to claim 5, **characterised in that** the measuring unit (1) is a flow sensor, in particular a calorimetric flow sensor (40, 50).

8. Measuring device according to one of claims 1 to 3, **characterised in that** the measuring unit (1) includes a gas analyser having a radiation source, which operates by the optical principle and is controlled by the alternating current (I(f)).

9. Measuring device according to one of the preceding claims, **characterised in that** the signal processing device (10) has a device for monitoring the signal pre-processing device (5) and the signal processing device (10) by comparing the fault signal value (20) with an expected value.

## Revendications

1. Appareil de mesure d'une grandeur non électrique
- comprenant une unité (1) de mesure, constituée pour transformer la grandeur (2) non électrique, indirectement au moyen d'un courant électrique alternatif de fréquence (f), en un signal (3) de mesure électrique, le signal (3) de mesure électrique comportant une proportion (3(2f)) de signal utile de fréquence (2f) doublée, qui dépend de la grandeur (2) non électrique, et une proportion (3(f)) de signal parasite de fréquence (f), qui dépend du courant (I(f)) alternatif,
- comprenant un dispositif (5) de prétransformation du signal pour transformer et numériser le signal (3) de mesure en un signal (9) de mesure,
- comprenant un dispositif (10) de transformation du signal pour transformer le signal (9) numérique au moyen d'un logiciel de transformation du signal en une valeur (11) de mesure, le logiciel de transformation du signal étant constitué pour
- détecter, d'une manière sensible à la phase à la fréquence (2f) doublée, le signal (9) numérique par multiplication (13) par un signal (14) de référence, et pour le transformer, par filtrage (15) passe bas ensuite, en la valeur (11) de mesure proportionnelle à la grandeur (2) non électrique et
- détecter, d'une manière sensible à la phase à la fréquence (f), le signal (9) numérique par multiplication (18) par un autre signal (19) de référence et le transformer en une valeur (20) de signal parasite par filtrage (15) passe bas ensuite,
**caractérisé**
- **en ce que** le dispositif (10) de transformation du signal a un étage (22) de normalisation, constitué pour normer, par formation d'un quotient, la valeur (11) de mesure par le carré de la valeur (20) du signal parasite et pour la sortir comme valeur (11') de valeur normée.

2. Appareil de mesure suivant la revendication 1, **caractérisé en ce que** le logiciel de transformation du signal transforme en alternance le signal (9) numérique détecté à la fréquence (2f) doublée et le signal (9) numérique détecté à la fréquence simple.

3. Dispositif de réglage suivant la revendication 1, **caractérisé en ce que** le logiciel de transformation du signal est présent en une réalisation doublée et transforme en parallèle le signal (9) numérique détecté à la fréquence (2f) doublée et le signal (9) numérique détecté à la fréquence simple.

4. Dispositif de réglage suivant l'une des revendications 1 à 3, **caractérisé en ce que** l'unité (1) de mesure comprend un analyseur (30) de gaz, fonctionnant par le procédé de pression alternée paramagnétique, en ayant un électroaimant (33), qui produit un champ magnétique à intensité du flux alternée et qui est commandé par le courant (I(f)) alternatif.

5. Dispositif de réglage suivant l'une des revendications 1 à 3, **caractérisé en ce que** l'unité (1, 40, 50, 60) de mesure comprend une résistance (43) chauffante, commandée par le courant (I(f)) alternatif et constituée pour transformer la grandeur non électrique suivant le principe thermo-physique en le signal (3) de mesure électrique.

6. Dispositif de réglage suivant la revendication 5, **caractérisé en ce que** l'unité (1) de mesure est un analyseur de gaz à conductivité de la chaleur.

7. Dispositif de réglage suivant la revendication 5, **caractérisé en ce que** l'unité (1) de mesure est un capteur d'écoulement, notamment un capteur (40, 50) d'écoulement calorimétrique.

8. Dispositif de réglage suivant l'une des revendications 1 à 3, **caractérisé en ce que** l'unité (1) de mesure comprend un analyseur de gaz, qui fonctionne suivant le principe optique et qui a une source de rayonnement commandée par le courant (I(f)) alternatif.

9. Dispositif de réglage suivant l'une des revendications précédentes, **caractérisé en ce que** le dispositif (10) de transformation du signal a des moyens de contrôle du dispositif (5) de prétransformation du signal et du dispositif (10) de transformation du signal par comparaison de la valeur (20) du signal parasite à une valeur escomptée.
